# FASCICULE DE BREVET EUROPEEN

(11) **EP 1 729 556 B1**
(45) Date de publication et mention de la délivrance du brevet: **18.08.2010**
(21) Numéro de dépôt: 06010732.3
(22) Date de dépôt: 24.05.2006
(51) Int. Cl.: H05K 7/14, H01R 12/06, H01R 12/16

(54) **Dispositif d'interconnexion reconfigurable de faisceaux électriques**
Rekonfigurierbare Verbindungsvorrichtung von elektrischen Kabelbäumen
Device for reconfigurable interconnection of wire harnesses

(30) Priorité: 30.05.2005 FR 0505463
(43) Date de publication de la demande: 06.12.2006
(73) Titulaire: EUROCOPTER, 13725 Marignane Cédex (FR)
(72) Inventeur: Imbert, Nicolas, 05380 Châteauroux Les Alpes (FR); Chuc, Charles, 13012 Marseille (FR)
(74) Mandataire: GPI & Associés

(56) Documents cités:
- EP-A- 1 221 829
- FR-A- 2 822 130
- US-A- 5 348 482
- US-A- 5 930 119
- US-B1- 6 504 730

## Description

La présente invention est relative à un dispositif d'interconnexion reconfigurable de faisceaux, câbles ou harnais électriques.

Le domaine technique de l'invention est celui de la fabrication de boîtiers de connexion de faisceaux électriques d'aéronefs à voilure tournante.

Il est important de pouvoir adapter (modifier) les connexions électriques entre les équipements (notamment capteurs, actionneurs, calculateurs) d'un aéronef, notamment pour faciliter l'installation et la maintenance d'équipements optionnels.

Pour éviter de fabriquer des faisceaux ou harnais spécifiques pour chaque configuration d'équipement, on prévoit des faisceaux ou harnais "standard", et on relie les équipements par leurs faisceaux respectifs, par l'intermédiaire d'un dispositif d'interconnexion de faisceaux qui est configurable/adaptable à différentes configurations d'équipement de l'aéronef.

Un tel dispositif peut comporter une matrice de broches, en particulier une matrice de broches de connecteurs juxtaposés, ainsi qu'une pluralité de fils électriquement conducteurs, chaque fil ou "pont" reliant deux broches. Notamment pour des raisons d'interchangeabilité des matériels ou équipements, les broches des connecteurs équipant les faisceaux ou harnais peuvent ne pas être "affectées" à un signal électrique déterminé. Il en résulte que ces dispositifs comportent un grand nombre de broches et de ponts.

La liaison électrique et mécanique entre l'extrémité d'un tronçon de fil ou pont et une des broches du dispositif peut être réalisée par enroulement (ou "wrapping").

Compte tenu des niveaux vibratoires élevés que doivent pouvoir supporter ces liaisons, ainsi que du niveau nécessaire de fiabilité requis pour ces liaisons, l'enroulement - manuel ou automatique - d'une extrémité d'un pont autour d'une broche doit être réalisé avec de grandes précautions, puis doit être contrôlé.

En outre, l'isolation électrique des broches ou extrémités de pont doit être réalisée, par exemple par dépôt (ou "imprégnation") d'une matière plastique isolante.

En pratique, de tels dispositifs doivent permettre l'interconnexion de plusieurs centaines de fils conducteurs de harnais.

Le brevet US 5,348,482 décrit un boîtier de jonction de faisceaux comportant un fond de panier, des cartes électroniques embrochables sur ce fond de panier, ainsi qu'une ou plusieurs cartes embrochables reconfigurables utilisant des ponts ou jonctions réalisés par enroulement ou par des circuits flexibles ; le fond de panier est constitué par une paroi supportant des connecteurs recevant les cartes embrochables, les broches de ces connecteurs étant reliées par des circuits flexibles aux broches des connecteurs d'entrée/sortie adaptés aux connecteurs équipant des harnais.

Ces dispositifs reconfigurables par des ponts enroulés sur des broches présentent l'inconvénient que pour modifier, supprimer ou ajouter un pont, il faut enlever le revêtement isolant, modifier la configuration des ponts, déposer une nouvelle couche de revêtement isolant et tester l'ensemble des connexions par enroulement ; ces opérations sont longues et coûteuses.

Il a par ailleurs été proposé dans le brevet FR 2822130 un module d'interconnexion comportant une paroi sur une première face de laquelle sont prévus des connecteurs de liaison avec des cordons de liaison, et sur une seconde face de laquelle sont prévus des connecteurs recevant trois types de cartes enfichables :
- des cartes de brassage comportant un circuit imprimé comportant des pistes assurant une connexion borne à borne des cordons de liaison ;
- des cartes de brassage et de connexion comportant des connecteurs adaptés aux connecteurs d'extrémité de harnais ; et
- des cartes de brassage et de connexion modifiables par mise en place manuelle de pontets.

Un tel dispositif n'est pas adapté aux aéronefs à voilure tournante pour lesquels il n'est pas nécessaire de relier des modules d'interconnexion par des cordons identiques.

Un objectif de l'invention est de proposer un système d'interconnexion de harnais facilement modifiable et compact.

Un objectif de l'invention est de proposer un dispositif d'interconnexion de faisceaux électriques qui soit amélioré et/ou qui remédie, en partie au moins aux inconvénients des dispositifs d'interconnexion connus.

Selon un premier aspect de l'invention, il est proposé un dispositif d'interconnexion de faisceaux électriques qui comporte plusieurs cartes embrochables de brassage et de connexion des faisceaux électriques ; le dispositif comporte en outre un circuit imprimé "principal" (ou "de distribution") équipé de connecteurs ou "slots" conçus et agencés pour recevoir les cartes embrochables, ce circuit imprimé comportant plusieurs pistes (de distribution) isolées parallèles permettant chacune de mettre au même potentiel deux pistes ou ébauches de pistes respectivement prévues sur deux cartes embrochables distinctes embrochées dans les connecteurs du circuit principal, chacune de ces pistes parallèles étant en contact avec une broche respective de plusieurs connecteurs du circuit imprimé principal.

Chaque carte de brassage et de connexion comporte un - ou est solidaire d'un - connecteur d'entrée/sortie adapté à un connecteur d'extrémité d'un des faisceaux à connecter.

De préférence, les connecteurs équipant le circuit imprimé et recevant les cartes de brassage et de connexion comportent au moins une rangée (par exemple quatre rangées) de broches s'étendant transversalement (de préférence perpendiculairement) aux pistes de distribution du circuit imprimé ; certaines au moins de ces broches sont au contact d'une des pistes de distribution.

De préférence encore, les pistes de distribution sont réparties sur plusieurs couches du circuit imprimé, de préférence sur quatre couches ou plus pour un hélicoptère ou autre aéronef ; dans ce cas notamment, le circuit imprimé comporte plusieurs dizaines ou centaines de pistes de distribution parallèles.

Chaque carte de brassage et de connexion comporte deux bords de préférence opposés et sensiblement parallèles : un premier bord par lequel la carte est reliée, embrochée ou insérée dans un des connecteurs ou "slots" du circuit imprimé, et un second bord distinct du premier bord par lequel la carte est reliée à au moins un - ou comporte au moins un - connecteur d'entrée/sortie adapté à un connecteur d'extrémité de faisceaux.

Chacune de ces cartes comporte en outre généralement plusieurs pistes ramifiées de connexion reliant le premier bord au second bord ainsi que, généralement, plusieurs ébauches de pistes ou pistes de brassage reliant au moins deux points - ou zones - distinct(e)s du premier bord.

Afin de faciliter encore la modification du dispositif, chacune de ces pistes de connexion comporte - ou est en contact avec - au moins un - et de préférence deux - organe(s) de dérivation tel(s) qu'une broche ou une portion de piste élargie (par exemple en forme de pastille).

Selon d'autres caractéristiques préférentielles de l'invention, les pistes parallèles du circuit imprimé principal sont isolées les unes des autres, rectilignes, de section identique.

Selon un mode préféré de réalisation, chacune des pistes parallèles du circuit imprimé principal est au contact d'une broche respective de chacun des connecteurs équipant le circuit imprimé principal.

Dans ce cas, le circuit imprimé principal ou fond de panier comporte un réseau de pistes parallèles sensiblement de même longueur et s'étendant d'une extrémité à l'autre du groupe des connecteurs du fond de panier qui s'étendent parallèlement les uns aux autres en formant une rangée de connecteurs.

De préférence également, ces connecteurs sont droits, sensiblement identiques et comportent chacun au moins une rangée (par exemple quatre rangées) de broches.

Selon un mode particulier de réalisation, chaque broche de l'un de ces connecteurs est au contact d'une piste ou d'une ébauche de piste de la carte fille qu'il reçoit.

Selon un mode préféré de réalisation, les pistes d'un circuit imprimé secondaire sont réparties sur plusieurs couches, en particulier deux couches.

D'autres caractéristiques et avantages de l'invention apparaissent dans la description suivante, qui se réfère aux dessins annexés et qui illustre, sans aucun caractère limitatif, des modes préférés de réalisation de l'invention.

La figure 1 est une vue en plan schématique d'un fond de panier selon un premier mode de réalisation d'un dispositif selon l'invention.

La figure 2 est une vue en plan schématique d'un fond de panier selon un second mode de réalisation d'un dispositif selon l'invention.

La figure 3 est une vue en plan schématique d'un fond de panier selon un troisième mode de réalisation d'un dispositif selon l'invention.

Les figures 4 et 5 illustrent un circuit imprimé principal à quatre couches qui est relié à un circuit flexible de raccordement ; la figure 4 est une vue en coupe longitudinale schématique du circuit imprimé équipé de cinq connecteurs ; la figure 5 est une vue en perspective schématique du circuit imprimé montrant les emplacements des connecteurs.

La figure 6 est une vue en perspéctive schématique d'une partie d'un système selon un autre mode de réalisation de l'invention qui comporte le circuit imprimé principal, trois cartes filles, ainsi qu'un circuit additionnel de brassage.

Les figures 7 à 10 illustrent un mode préféré de réalisation d'un dispositif selon l'invention ; les figures 7 à 9 illustrent respectivement en vue de dessous, en vue de coté, et en vue de dessus un coffret de jonction équipé de dix connecteurs complémentaires de connecteurs terminaux (non représentés) de faisceaux à relier par ce dispositif ; la figure 10 est une vue en perspective éclatée montrant schématiquement le montage mécanique des principaux éléments de ce coffret.

La figure 11 est une vue en plan schématique du circuit de fond de panier de la figure 12.

La figure 12 illustre schématiquement en vue de coté un fond de panier recevant cinq cartes filles et relié à un circuit de brassage par une nappe flexible, comme c'est le cas du dispositif de la figure 10.

La figure 13 est une vue en plan schématique d'un circuit imprimé secondaire d'un appareil selon l'invention.

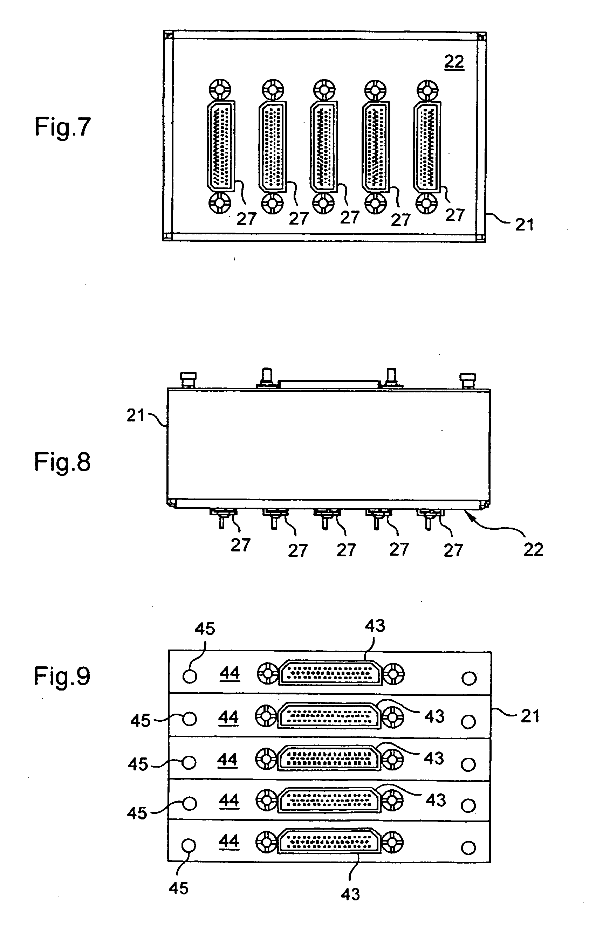

Par référence aux figures 7 à 10 en particulier, le dispositif 20 comporte un boîtier 21 de forme parallélépipédique qui comporte une paroi 22 de fond percée de cinq ouvertures 23.

Le dispositif comporte en outre un fond de panier 24 et un circuit 25 de brassage qui sont reliés par une nappe flexible 26. Cinq connecteurs identiques 27 sont montés sur la face inférieure du circuit 25 ; ces connecteurs sont destinés à coopérer avec des connecteurs terminaux (non représentés) des faisceaux à relier par le dispositif 20 ; les ouvertures 23 ont une forme adaptée à celle des connecteurs 27 qui, en position de montage s'étendent au travers de celles-ci et sont saillants par rapport au fond du boîtier, comme illustré figure 8 notamment.

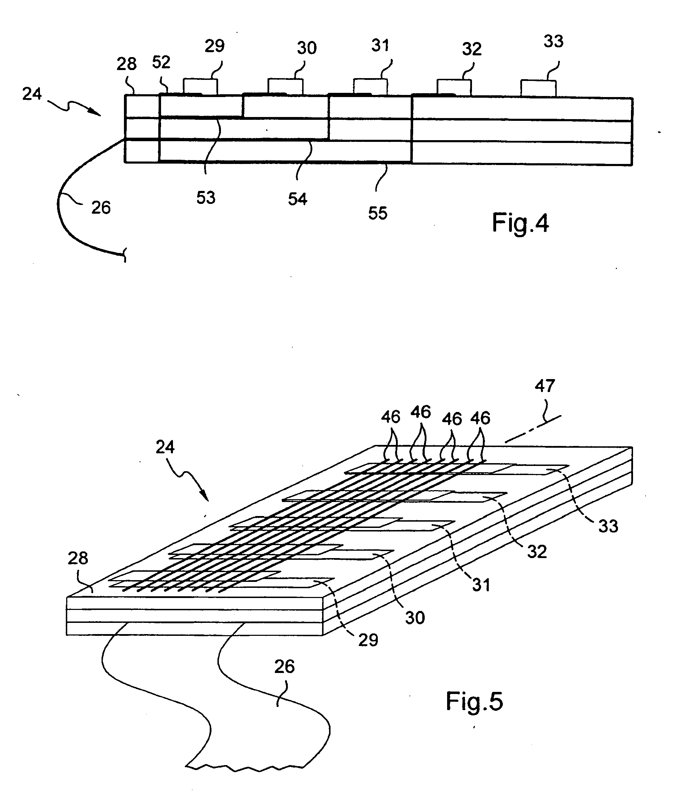

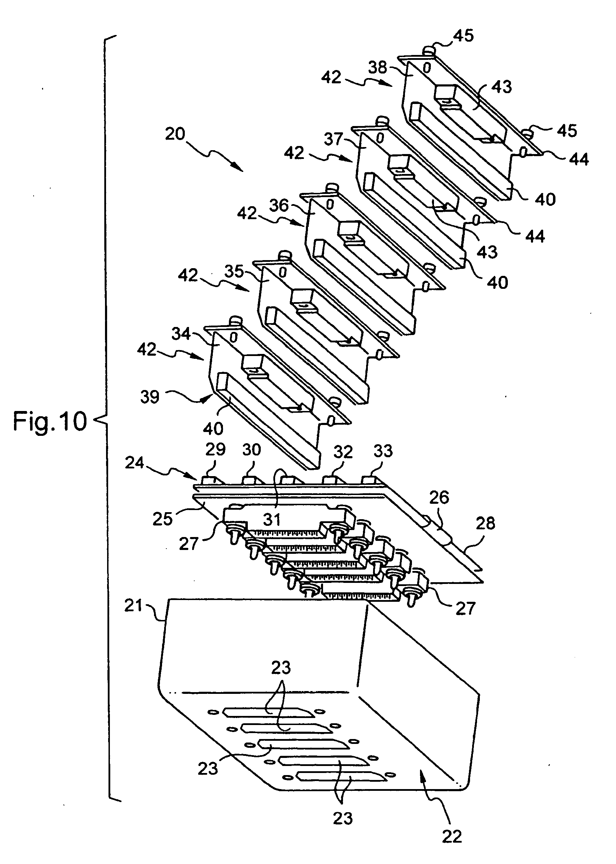

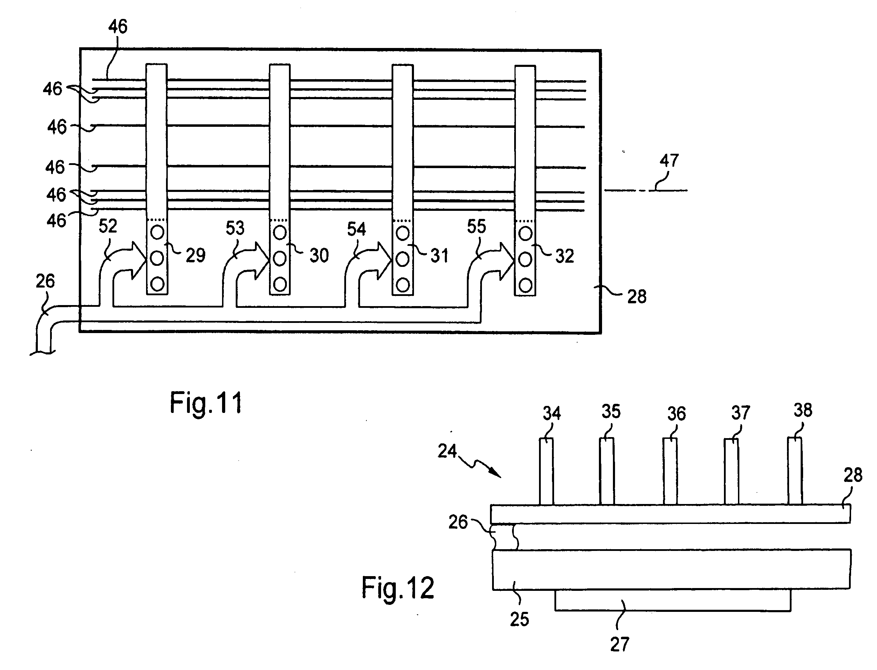

Par référence aux figures 4, 6, 10 et 12 en particulier, le fond de panier 24 comporte un circuit imprimé principal 28 sur une face supérieure duquel sont fixés des connecteurs 29 à 33 (figures 4 et 10) prévus pour recevoir - de façon amovible - un nombre correspondant de circuits imprimés secondaires - ou cartes filles - 34 à 38.

La liaison mécanique et la connexion électrique de chacune des cartes filles et du connecteur de fond de panier correspondant peut s'effectuer par embrochage ou insertion ; dans le premier cas correspondant à la figure 10, chaque carte fille - telle que celle repérée 34 - est munie le long de son bord inférieur 39 d'un connecteur 40 choisi pour pouvoir s'embrocher et se fixer sur le connecteur correspondant 29 du fond de panier 24.

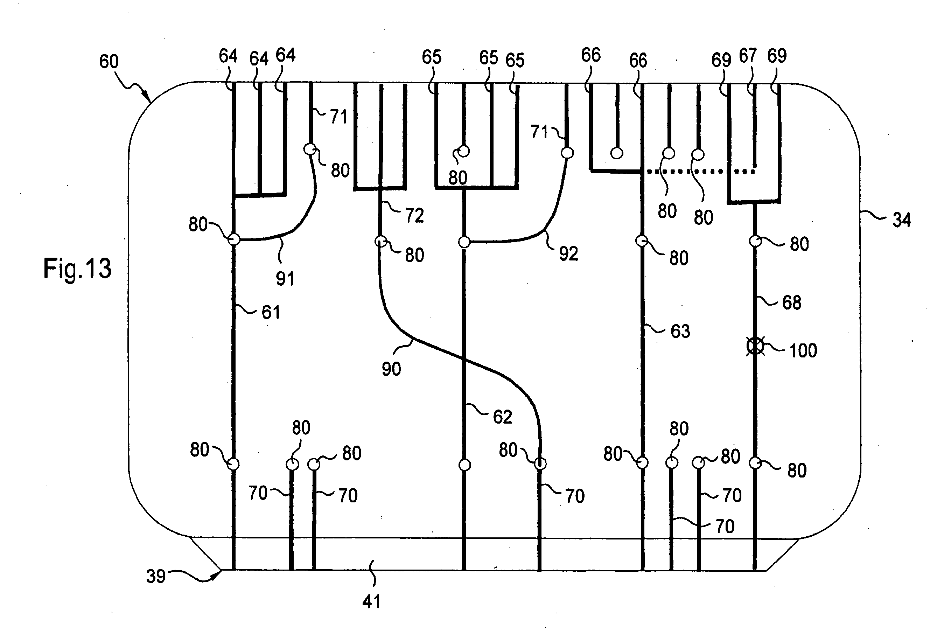

Dans le second cas correspondant à la figure 13, la carte 34 présente une portion 41 s'étendant à partir du bord 39 inférieur de la carte, dont la forme et les dimensions sont adaptées à celle d'une fente prévue dans les connecteurs du fond de panier destinés à la recevoir "sans jeu".

Dans le mode de réalisation des figures 7 à 10, chaque carte fille fait partie d'un module 42 amovible du dispositif ; chaque module 42 comporte, outre la carte 34 à 38 et son connecteur 40 associé de liaison avec le fond de panier, une platine 44 de fixation et un connecteur 43 d'entrée/sortie s'étendant au travers de la platine correspondante. La platine 44 sert à la fixation du module 42 dont elle fait partie, au boîtier 21, par deux vis 45. Chaque carte fille 34 comporte des pistes comme illustré figure 13 ; les broches du connecteur 40 - lorsqu'il est prévu - sont au contact d'extrémités de pistes de la carte ; il en est de même des broches du connecteur 43 d'entrée/sortie qui est complémentaire d'un connecteur terminal (non représenté) d'un faisceau à connecter au dispositif.

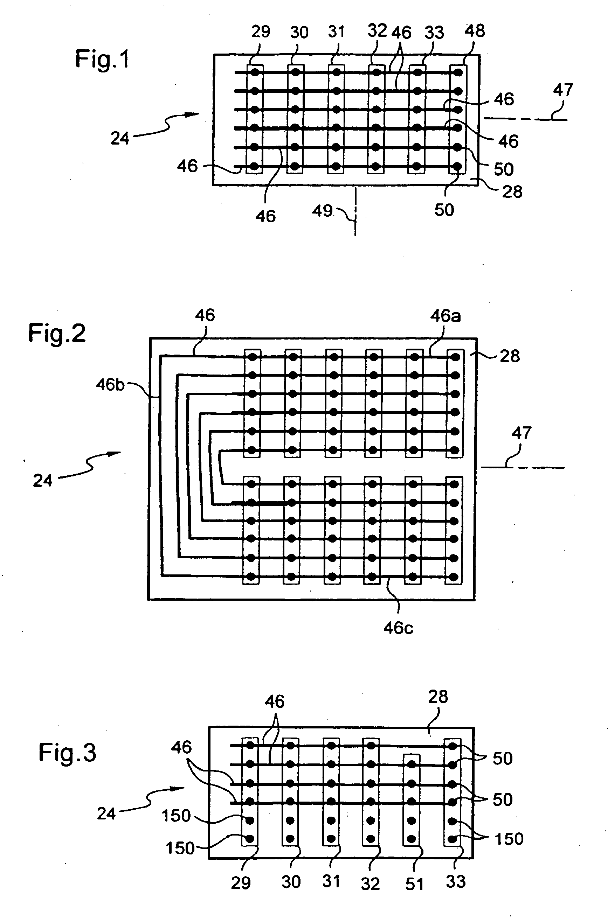

Le circuit imprimé principal 28 figure 1 comporte six pistes 46 rectilignes, régulièrement espacées les unes des autres, de même longueur et de même section, s'étendant le long d'un axe 47 ; le circuit 28 reçoit six connecteurs 29 à 33 et 48, qui sont également régulièrement espacés, de même longueur, et qui s'étendent parallèlement à un axe 49 orthogonal à l'axe 47. Chacun de ces connecteurs comporte six broches 50 identiques régulièrement espacées d'un pas identique au pas d'espacement des pistes 46, selon l'axe 49 ; toutes les broches de chaque connecteur sont au contact de l'une des pistes 46, chaque piste 46 assurant ainsi une liaison équipotentielle entre les broches concernées des six connecteurs 29 à 33.

Dans la variante illustrée figure 3, un connecteur 51 du fond de panier 24 présente une broche de moins que les autres connecteurs 29 à 33 ; en outre, deux broches 150 de chacun des connecteurs 29 à 33, 51 ne sont pas reliées à des pistes du réseau de quatre pistes parallèles 46, contrairement aux autres broches 50 des connecteurs.

Dans la variante illustrée figure 2, chaque piste 46 comporte deux portions 46a, 46c rectilignes parallèles à l'axe 47, ainsi qu'une portion 46b reliant les portions 46a et 46c entre elles. D'une façon générale les pistes 46 forment un réseau d'équipotentielles parallèles non ramifiées reliant - broche à broche - les connecteurs 29 à 33, 51 du fond de panier qui sont destinés à recevoir les cartes filles.

Dans les modes de réalisation illustrés figures 4, 5 et 10 à 12, les connecteurs (de transport de signaux) d'entrée/sortie forment deux groupes distincts :
- un premier groupe de cinq connecteurs 27 fixés et reliés à un circuit imprimé 25, et
- un second groupe de cinq connecteurs 43 respectivement reliés au circuit imprimé 28 par les cartes 34 à 38.

Les circuits 25 et 28 sont disposés en regard l'un de l'autre et sont reliés par la nappe 26.

Cette configuration peut par exemple être utilisée en connectant aux connecteurs 27 du dispositif 20 les faisceaux (non représentés) des appareils et des équipements "standard" d'un aéronef, et en connectant les faisceaux (non représentés) des équipements optionnels aux connecteurs 43 des cartes filles ; dans ce cas notamment, le circuit imprimé 25 peut être conçu pour assurer l'interconnexion - ou brassage - des signaux transportés par les faisceaux des équipements standard, tandis que le circuit 28 est conçu pour d'une part assurer le partage de signaux entre les équipements optionnels, par l'intermédiaire du réseau des pistes parallèles, et d'autre part permettre la distribution (le partage) de signaux entre les équipements optionnels et les équipements "standard".

Dans cette configuration illustrée figure 4, 5 et 11, le réseau de pistes équipotentielles parallèles 46 occupe une première partie du circuit 28, tandis que d'autres pistes relient certaines broches de connecteurs 29 à 32 du fond de panier aux conducteurs de la nappe flexible 26 :
- un premier groupe de pistes 52 relie le connecteur 29 à la nappe 26 ;
- un second groupe de pistes 53 relie le connecteur 30 à la nappe 26 ;
- un troisième groupe de pistes 54 relie le connecteur 31 à la nappe 26 ;
- un quatrième groupe de pistes 55 relie le connecteur 32 à la nappe 26.

Comme illustré figure 4, ces pistes 52 à 55 sont reparties sur quatre couches superposées du circuit 28.

Dans le cas d'un fond de panier correspondant des connecteurs (repères 29 à 33, 51) à 144 broches, on peut par exemple relier environ deux tiers des broches (par exemple 100 broches) de chaque connecteur aux pistes (par exemple 100 pistes) 46 du réseau d'équipotentielles, et relier le relicat (un tiers environ) des broches de chaque connecteur à des conducteurs de la nappe 26 de liaison avec le circuit 25 de brassage des signaux d'entrée/sortie (présentés sur les broches des connecteurs 27).

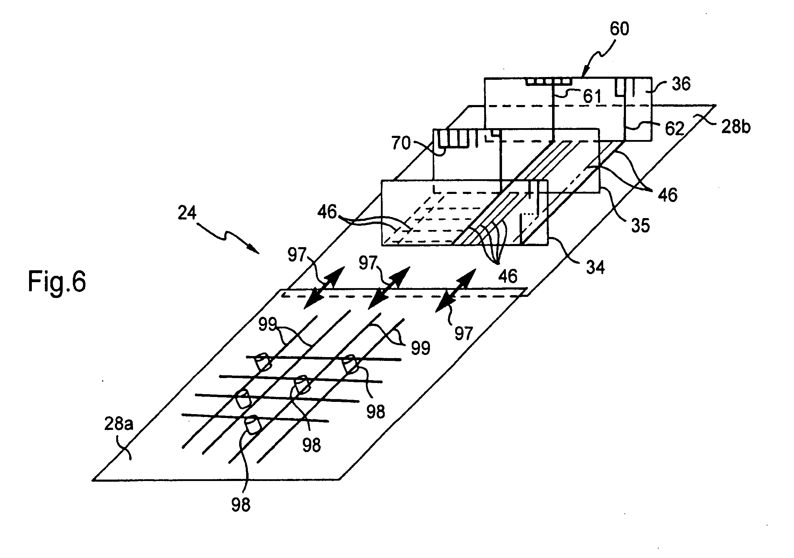

Par référence aux figures 6 et 13 en particulier, chaque carte 34 comporte plusieurs pistes ramifiées s'étendant entre son bord 39 d'insertion dans un "slot" du fond de panier, et son bord 60 opposé.

Par référence à la figure 13 en particulier, chacune des pistes 61 à 63 présente un "tronc" s'étendant à partir du bord 39 en direction du bord opposé 60, ainsi que trois "branches" 64 à 67 s'étendant à partir du "tronc" jusqu'au bord 60.

De façon similaire, la piste 68 comporte un tronc prolongé par deux branches 69 seulement.

Pour ce qui concerne la piste 63, deux de ses branches repérées 66 s'étendent sur une première face ou couche du circuit 34, tandis que sa troisième branche 67 s'étend sur une seconde face ou couche du circuit 34.

Chacune de ces pistes ramifiées permet de mettre au même potentiel au moins deux broches d'un premier connecteur (tel que ceux repérés 43 figure 10) fixé ou inséré le long du bord 60 de la carte 34, et une broche d'un connecteur fixé le long du - ou recevant le - bord 39 de la carte 34.

Le circuit 34 comporte en outre une pluralité d'ébauches (70 à 72) de pistes qui s'étendent pour les unes à partir du bord 39 et pour les autres à partir du bord 60 opposé au bord 39, sans rejoindre le bord opposé ; chacune de ces ébauches de piste se termine par une portion 80 élargie en forme de disque ou "pastille" ; chacune des pistes 61 à 63 et 68 comporte également deux telles portions élargies ou pastilles.

Les pistes et leurs "pastilles" sont normalement revêtues d'un isolant, en particulier d'un film ou revêtement électriquement isolant.

Les portions élargies 80 permettent, après qu'elles aient été débarrassées de leur revêtement isolant, de réaliser une connexion ou "pont" entre deux pistes ou ébauches de pistes de la carte 34, par soudure des extrémités d'un tronçon 90 à 92 de fil conducteur sur les pastilles correspondantes ; en particulier, on voit figure 13 qu'un pont 90 relie la pastille 80 d'une ébauche de piste 70 non ramifiée à la pastille 80 d'une ébauche 72 de piste ramifiée ; il en est de même des ponts 91 et 92.

Ainsi, les deux portions élargies 80 dont sont munies chacune des pistes "continues", ainsi que la portion élargie 80 dont sont munies chacune des pistes interrompues (ou ébauches de pistes) facilite la modification par "pontage" de la configuration d'interconnexion ou "brassage" de chacune des cartes filles 34.

On comprend également que l'utilisation conjointe de ces cartes filles avec un fond de panier doté d'un réseau d'équipotentielles - dont certaines peuvent être inutilisées, c'est-à-dire raccordées à aucune broche d'aucun des connecteurs d'entrée/sortie - facilite la modification et la maintenance du dispositif 20 d'interconnexion de faisceaux électriques. A ce sujet, on peut noter qu'une piste telle que la piste 68 figure 13 peut être rapidement transformée en deux ébauches de pistes isolées en détruisant (par perçage par exemple) une portion 100 de la piste située entre les deux portions élargies 80.

En variante, les portions élargies 80 peuvent être remplacées par des organes de liaison équipotentielle mâles (tels que broches ou ergots) ou femelles (tels que pinces) de forme complémentaire à des organes de connexion équipant les extrémités des tronçons de fils de pontage.

La modification, l'ajout ou le retrait d'une carte fille d'un système selon l'invention est simple et rapide ; en outre, un "slot" libre au moins peut être prévu sur le fond de panier pour recevoir de façon temporaire une carte spécialement conçue pour la maintenance ou le diagnostic des faisceaux et/ou équipements interconnectés par le dispositif 20.

Dans le mode de réalisation illustré figure 6, le circuit imprimé principal 28 comporte une première partie 28b équipée d'un réseau d'équipotentielles parallèles 46 reliant des connecteurs recevant les cartes filles 34 à 36, ainsi qu'une seconde partie 28a équipée de connecteurs d'entrée/sortie (non représentés) ; un brassage par des ponts reliant des broches 98 du circuit 28a est prévu, ainsi que des liaisons 97 pour relier certaines des pistes 99 de la partie 28a aux équipotentielles 46 de la partie 28b.

## Revendications

1. Dispositif (20) d'interconnexion de faisceaux électriques qui comporte plusieurs cartes (34 à 38) embrochables de brassage et de connexion des faisceaux électriques,
un circuit imprimé principal (28, 28b) équipé de connecteurs (29 à 33) conçus et agencés pour recevoir les cartes embrochables, **caractérisé en ce que** le circuit imprimé principal comporte plusieurs pistes (46) parallèles permettant chacune de mettre au même potentiel deux pistes (61 à 63, 68) ou ébauches (70 à 72) de pistes respectivement prévues sur deux cartes embrochables distinctes embrochées dans les connecteurs du circuit imprimé principal, chacune de ces pistes (46) parallèles étant en contact avec une broche (50, 150) respective de plusieurs connecteurs du circuit imprimé principal.

2. Dispositif selon la revendication 1, dans lequel chaque carte embrochable de brassage et de connexion comporte un - ou est solidaire d'un - connecteur (43) d'entrée/sortie adapté à un connecteur d'extrémité d'un des faisceaux à connecter.

3. Dispositif selon la revendication 1 ou 2, dans lequel les connecteurs (29 à 33) équipant le circuit imprimé principal et recevant les cartes de brassage et de connexion comportent au moins une rangée de broches (50, 150) s'étendant transversalement aux pistes (46) parallèles de distribution du circuit imprimé, et dans lequel certaines au moins de ces broches sont au contact d'une des pistes parallèles de distribution.

4. Dispositif selon l'une quelconque des revendications 1 à 3, dans lequel les pistes (46) de distribution sont réparties sur plusieurs couches du circuit imprimé principal (28, 28b).

5. Dispositif selon l'une quelconque des revendications 1 à 4, dans lequel le circuit imprimé principal comporte plusieurs dizaines ou centaines de pistes (46) parallèles non ramifiées.

6. Dispositif selon l'une quelconque des revendications 1 à 5, dans lequel chaque carte embrochable de brassage et de connexion comporte deux bords de préférence opposés et sensiblement parallèles : un premier bord (39) par lequel la carte est reliée, embrochée ou insérée dans un des connecteurs du circuit imprimé, et un second bord (60) distinct du premier bord par lequel la carte est reliée à au moins un - ou comporte au moins un - connecteur d'entrée/sortie adapté à un connecteur d'extrémité de faisceaux

7. Dispositif selon l'une quelconque des revendications 1 à 6, dans lequel chacune des cartes embrochables comporte plusieurs pistes (61 à 63, 68) ramifiées de connexion reliant le premier bord au second bord ainsi que plusieurs ébauches (70 à 72) de pistes ou pistes de brassage susceptibles de relier au moins deux points - ou zones - distinct(e)s du premier bord.

8. Dispositif selon l'une quelconque des revendications 1 à 7, dans lequel chacune des pistes (61 à 63, 68) de connexion comporte - ou est en contact avec - deux organes (80) de dérivation tels qu'une broche, une portion de piste élargie ou une pince.

9. Dispositif selon l'une quelconque des revendications 1 à 8, dans lequel les pistes parallèles (46) du circuit imprimé principal sont isolées les unes des autres, rectilignes, de section identique.

10. Dispositif selon l'une quelconque des revendications 1 à 9, dans lequel chacune des pistes (46) parallèles du circuit imprimé principal (28, 28b) est au contact d'une broche (50, 150) respective de chacun des connecteurs équipant le circuit imprimé principal.

11. Dispositif selon l'une quelconque des revendications 1 à 10, dans lequel le circuit imprimé principal ou fond de panier comporte un réseau de pistes parallèles (46) sensiblement de même longueur et s'étendant d'une extrémité à l'autre du groupe des connecteurs (29 à 33) du fond de panier qui s'étendent parallèlement les uns aux autres en formant une rangée de connecteurs.

12. Dispositif selon l'une quelconque des revendications 1 à 11, dans lequel les connecteurs (29 à 33) sont droits, sensiblement identiques et comportent chacun au moins une rangée de broches (50, 150).

13. Dispositif selon l'une quelconque des revendications 1 à 12, dans lequel chaque broche de l'un des connecteurs (29 à 33) est au contact d'une piste ou d'une ébauche de piste de la carte fille qu'il reçoit.

14. Dispositif selon l'une quelconque des revendications 1 à 13, dans lequel les pistes (61 à 63, 68) ou ébauches de pistes (70 à 72) d'un circuit imprimé secondaire sont réparties sur plusieurs couches, en particulier deux couches.

## Claims

1. Device (20) for interconnecting electrical bundles which comprises a plurality of pluggable cards (34 to 38) for connecting and cross-connecting electrical bundles, a main printed circuit (28, 28b) fitted with connectors (29 to 33) designed and arranged to receive the pluggable cards, **characterised in that** the main printed circuit has a plurality of parallel tracks (46), each enabling two tracks (61 to 63, 68) or track starters (70 to 72) respectively provided on two distinct pluggable cards plugged into the connectors of the main printed circuit to be set to the same potential, each of these parallel tracks (46) being in contact with a respective pin (50, 150) of a plurality of connectors of the main printed circuit.

2. Device according to Claim 1, in which each pluggable connection and cross-connect card includes or is secured to an input/output connector (43) adapted to an end connector of one of the bundles to be connected.

3. Device according to Claim 1 or 2, in which the connectors (29 to 33) fitted to the main printed circuit and receiving the connection and cross-connect cards include at least one row of pins (50, 150) extending transversely to the parallel distribution tracks (46) of the printed circuit, and in which at least some of these pins are in contact with one of the parallel distribution tracks.

4. Device according to any one of Claims 1 to 3, in which the distribution tracks (46) are distributed in a plurality of layers of the main printed circuit (28, 28b).

5. Device according to any one of Claims 1 to 4, in which the main printed circuit comprises several tens or hundreds of non-branching parallel tracks (46).

6. Device according to any one of Claims 1 to 5, in which each pluggable connection and cross-connect card has two edges that are preferably opposite and substantially parallel: a first edge (39) whereby the card is connected, plugged, or inserted in one of the connectors of the printed circuit; and a second edge (60) distinct from the first edge whereby the card is connected to, or includes, at least one input/output connector adapted to an end connector of bundles.

7. Device according to any one of Claims 1 to 6, in which each of the pluggable cards has a plurality of branching connection tracks (61 to 63, 68) connecting the first edge to the second edge, together with a plurality of track starters (70 to 72) or cross-connect tracks suitable for connecting at least two distinct points (or zones) of the first edge.

8. Device according to any one of Claims 1 to 7, in which each of the connection tracks (61 to 63, 68) includes, or is in contact with, two branch connection members (80) such as a pin, a wide portion of track or a clamp.

9. Device according to any one of Claims 1 to 8, in which the parallel tracks (46) of the main printed circuit are insulated from one another, rectilinear, and of identical section.

10. Device according to any one of Claims 1 to 9, in which each of the parallel tracks (46) of the main printed circuit (28, 28b) is in contact with a respective pin (50, 150) of each of the connectors fitted to the main printed circuit.

11. Device according to any one of Claims 1 to 10, in which the main printed circuit or backplane includes an array of parallel tracks (46) of substantially the same length extending from one edge to the other of the group of connectors (29 to 33) of the backplane which extend parallel to one another and form a row of connectors.

12. Device according to any one of Claims 1 to 11, in which the connectors (29 to 33) are straight, substantially identical, and each include at least one row of pins (50, 150).

13. Device according to any one of Claims 1 to 12, in which each pin of one of the connectors (29 to 33) is in contact with a track or a track starter of the daughter card which it receives.

14. Device according to any one of Claims 1 to 13, in which the tracks (61 to 63, 68) or track starters (70 to 72) of a secondary printed circuit are distributed in a plurality of layers, in particular two layers.

## Patentansprüche

1. Vorrichtung (20) zur Verbindung elektrischer Kabelbäume mit mehreren Einsteckkarten (34 bis 38) zum Trennen/Vermischen und Verbinden elektrischer Kabelbäume, mit
einem gedruckten Hauptschaltkreis (28, 28b), der mit Verbindern (29 bis 33) versehen ist, die derart ausgebildet und angeordnet sind, dass sie die Einsteckkarten aufnehmen können, **dadurch kennzeichnet, dass**
der gedruckte Hauptschaltkreis mehrere parallel Leiterbahnen (46) aufweist, die es jeweils ermöglichen zwei Leiterbahnen (61 bis 63, 68) oder Rohformen von Leiterbahnen (70 bis 72), die jeweils auf zwei unterschiedlichen Steckkarten vorgesehen sind, die in die Verbinder des gedruckten Hauptschaltkreises eingesteckt sind auf ein gleiches Potential zu halten, wobei jede der parallelen Leiterbahnen (46) mit einem Steckerstift (50, 150) mehrerer Verbinder des gedruckten Hauptschaltkreises in Kontakt steht.

2. Vorrichtung nach Anspruch 1, bei der jede Einsteckkarte zum Mischen/Trennen und Verbinden eines Eingangs-(43)/Ausgangs-Verbinders aufweist oder mit einen solchen fest verbunden ist, der passend zu einem Endverbinder eines zu verbindenden Kabelbaums passend ausgelegt ist.

3. Vorrichtung nach Anspruch 1 oder 2, bei der die Verbinder (29 bis 33), mit denen der gedruckte Hauptschaltkreis ausgerüstet ist und die die Einsteckkarten zum Mischen/Trennen und Verbinden mindestens eine Reihe von Steckerstiften (50, 150) aufweisen, die sich quer zu den parallelen Verteilungsleiterbahnen (46) des gedruckten Hauptschaltkreises erstrecken, und wobei wenigstens bestimmte dieser Steckerstifte mit einer der parallelen Verteilerleiterbahnen in Kontakt stehen.

4. Vorrichtung nach einem der Ansprüche 1 bis 3, bei der die Verteilerleiterbahnen (46) auf mehrere Schichten des gedruckten Hauptschaltkreises (28, 28b) verteilt sind.

5. Vorrichtung nach einem der Ansprüche 1 bis 4, bei der der gedruckte Hauptschaltkreis mehrere Dutzend oder Hunderte parallele nicht verzweigte Leiterbahnen (46) aufweist.

6. Vorrichtung nach einem der Ansprüche 1 bis 5, bei der jede Einsteckkarte zum Mischen/Trennen und Verbinden zwei sich vorzugsweise gegenüberliegende im Wesentlichen parallel zueinander verlaufende Unterkarten (39) aufweist: Eine erste Unterkarte (39), mit der die Karte in einem der Verbinder des gedruckten Hauptschaltkreises eingeschoben, eingesteckt und mit diesem verbunden ist und eine zweite Unterkarte (60), die von der ersten Unterkarte verschieden ist und mit der die Karte mit mindestens einen Eingangs/Ausgangs-Verbinder verbunden ist - oder einen solchen aufweist - der an einen Endverbinder des Kabelbaums angepasst ist.

7. Vorrichtung nach einem der Ansprüche 1 bis 6, bei der jede der Einsteckkarten mehrere nichtverzweigte Leiterbahnen (61 bis 63, 68) aufweist, die zur Verbindung dienen und die erste Unterkarte mit der zweiten Unterkarte sowie mehrere Rohlinge (70 bis 72) von Leiterbahnen oder Leiterbahnen zum Mischen/Trennen aufweist, die mindestens zwei verschiedene Punkte - oder Bereiche - der ersten Unterkarte verbinden können.

8. Vorrichtung nach einem der Ansprüche 1 bis 7, bei der jede der Verbindungsleiterbahnen (61 bis 63, 68) zwei Umleitungselemente (80) aufweist - oder mit diesen in Kontakt steht -, wie einen Steckerstift, einen Teil einer verbreiterten Leiterbahn oder eine Klemme.

9. Vorrichtung nach einem der Ansprüche 1 bis 8, bei der die parallelen Leiterbahnen (46) des gedruckten Hauptschaltkreises voneinander isoliert sind, gradlinig verlaufen und einen identischen Querschnitt aufweisen.

10. Vorrichtung nach einem der Ansprüche 1 bis 9, bei der jede der parallelen Leiterbahnen (46) des gedruckten Hauptschaltkreises (28, 28b) in Kontakt mit einem jeweiligen Steckerstift (50, 150) eines jeden Verbinders, mit dem der gedruckte Hauptschaltkreis ausgerüstet ist, in Kontakt steht.

11. Vorrichtung nach einem der Ansprüche 1 bis 10, bei der der gedruckte Hauptschaltkreis ein Netzwerk paralleler Leiterbahnen (46) aufweist, mit im Wesentlichen gleicher Länge und die sich von einem Ende zum anderen der Gruppe von Verbindern (29 bis 33) des gedruckten Hauptschaltkreises erstrecken und die sich parallel zueinander erstrecken und eine Reihe von Verbindern bilden.

12. Vorrichtung nach einem der Ansprüche 1 bis 11, bei der die Verbinder (29 bis 33) gradlinig und im Wesentlichen identisch sind und jeweils mindestens eine Reihe von Steckerstiften (50, 150) aufweisen.

13. Vorrichtung nach einem der Ansprüche 1 bis 12, bei der jeder Steckerstift eines der Verbinder (29 bis 33) in Kontakt mit einer Leiterbahn oder einem Rohling einer Leiterbahn der Tochterkarte steht, die ihn aufnimmt.

14. Vorrichtung nach einem der Ansprüche 1 bis 13, bei der die Leiterbahn (61 bis 63, 68) oder Rohlinge von Leiterbahnen (70 bis 72) einer sekundären gedruckten Schaltung über mehrere Schichten, insbesondere zwei Schichten, verteilt angeordnet sind.
